# EUROPÄISCHE PATENTANMELDUNG

(11) **EP 3 955 016 A1**
(43) Veröffentlichungstag der Anmeldung: **16.02.2022**
(21) Anmeldenummer: 21189880.4
(22) Anmeldetag: 05.08.2021
(51) Int. Cl.: G01R 33/022, G01R 33/032, G01R 33/26

(54) **GRADIOMETER ZUR ERFASSUNG EINES GRADIENTENFELDES EINER PHYSIKALISCHEN GRÖSSE**

(30) Priorität: 12.08.2020 DE 102020210245
(71) Anmelder: Universität Stuttgart, 70174 Stuttgart (DE)
(72) Erfinder: Niethammer, Matthias, 70469 Stuttgart (DE); Widmann, Matthias, 72622 Nürtingen (DE); Wrachtrup, Jörg, 70569 Stuttgart (DE)
(74) Vertreter: FDST Patentanwälte

(57) **Zusammenfassung**

Die Erfindung betrifft ein Gradiometer (2, 2') zur Erfassung eines Gradientenfeldes einer physikalischen Größe, aufweisend einen Kristallkörper (4) mit mindestens einem optisch aktiven Kristallgitterdefekt (6), welches als Reaktion auf ein Anregungslicht ein Emissionslicht in Abhängigkeit der physikalischen Größe emittiert, und eine Lichteinkopplung (14) zur Einkopplung von Anregungslicht, sowie eine Detektionseinheit (22) zur Detektion von Emissionslicht, wobei die Lichteinkopplung (14) und die Detektionseinheit (22) an zueinander senkrecht orientierten Flächen (12, 10) des Kristallkörpers (4) angeordnet sind, und wobei zwischen der Detektionseinheit (22) und dem Kristallkörper (4) eine das Emissionslicht zumindest bereichsweise blockierende Struktur (18, 18', 18") vorgesehen ist, welche zumindest einen für das Emissionslicht transparenten Bereich (24) aufweist.

## Beschreibung

Die Erfindung liegt auf dem Gebiet der Sensortechnologie, insbesondere der kristalldefekt-basierten Sensortechnologie, wobei Defekte oder Verunreinigungen eines Kristallgitters als Sensoren oder Sonden für physikalische Größen verwendet werden.

Sogenannte Spin-Verunreinigungen oder Spin-Defekte in Feststoffen gehören zu den bisher bekanntesten und meist untersuchten Quantensystemen. Insbesondere Farbzentren in Diamanten, wie beispielsweise das negativ geladene Stickstofffehlstellen-Zentrum (engl.: nitrogen vacancy center, NV), haben sich als vielseitige, atomgroße Spin-Systeme mit einer Vielzahl von Anwendungen in der Quantenoptik, der Informationsverarbeitung und der Quantensensorik erwiesen.

Im einfach negativ geladenen Zustand weist ein solches Stickstofffehlstellen-Zentrum ein Spin-1 Elektronenspinmoment mit einem Grundzustand mit einer Nullfeldaufspaltung (engl.: zero field splitting, ZFS) von 2.87 GHz (Gigahertz) zwischen einem nicht-magnetischen Zustand ("0") und den dazugehörigen magnetischen Zuständen ("+1", "-1") auf, sodass eine einfache Manipulation des Elektronenspinmoments mittels Einstrahlung von Hochfrequenzpulsen im Mikrowellenbereich ermöglicht ist.

Bei einer Beleuchtung oder Bestrahlung mit einem grünen mit (Laser-)Licht wird das Elektronenspinmoment des Stickstofffehlstellen-Zentrum einerseits im Wesentlichen vollständig in den nicht-magnetischen Grundzustand ("0") polarisiert. Andererseits emittiert das NV-Zentrum bei einer Anregung Licht im roten Wellenlängenbereich, wobei die Anzahl der Photonen abhängig vom Spinzustand des Elektronenspinmoments vor der Bestrahlung ist. Mit anderen Worten ist der Zustand des Elektronenspinmoments des NV-Zentrums durch Erfassung der emittierten Photonen optisch auslesbar, sodass eine besonders einfache Detektion des Spinzustands möglich ist.

Der Spinzustand des Elektronenspinmoments ist in Abhängigkeit von Stärke und/oder räumlichen Orientierung einer physikalischen Größe, wie beispielsweise einem mechanischen Druck, einer Temperatur, oder einem elektrischen oder magnetischen Feld, beeinflussbar. Somit variiert die Anzahl der emittierten Photonen, also die Stärke des Emissionslichts, in Abhängigkeit der Stärke und/oder Orientierung der physikalischen Größe, so dass sich NV-Zentren als optische Sensoren oder Sonden für unterschiedliche physikalische Größen eigenen.

Herkömmlicherweise wird bei derartigen NV-Sensorsystemen ein sogenanntes axiales Sensordesign (Durchlichtgeometrie) verwendet, bei welchem die optische Anregung entlang einer spezifischen Achse des Kristalls erfolgt. In der Regel stimmt diese Achse mit der Detektionsachse überein. Mit anderen Worten sind das Anregungslicht (Laserlicht) und das zu detektierende Emissionslicht (Fluoreszenzlicht) parallel oder koaxial zueinander ausgerichtet, so dass das Anregungslicht und das Emissionslicht überlagert sind. Hierbei sind zur Detektion zusätzliche, kostenintensive, optische Filter notwendig, um das Anregungslicht und das Emissionslicht zu trennen.

In manchen Anwendungen ist zusätzlich zum Filter ein Strahlteiler vorgesehen, welcher beispielsweise das Anregungslicht reflektiert und für das Emissionslicht transparent ist. Derartige Strahlteiler schwächen das Emissionslicht zumindest teilweise ab, so dass das zu detektierende Signal nachteilig reduziert wird.

Axiale Sensorsysteme weisen weiterhin den Nachteil auf, dass der Kristall, also das Sensorelement, zwischen der Anregung und der Detektion angeordnet ist. Durch diese mittige Anordnung wird die Sensitivität des Sensors nachteilig eingeschränkt.

Aus der DE 10 2018 214 617 A1 ist ein Sensorsystem mit einer axialen Sensorgeometrie bekannt, bei welchem eine Gradientenbrechungsindexlinse (GRIN) als Lichteinkopplung in eine Planseite oder Planfläche eines Kristallkörpers (Diamant) verwendet wird, um Totalreflektionen weitestmöglich zu vermeiden. Das Fluoreszenzlicht der Kristalldefekte tritt an der der Linse gegenüberliegenden Planseite aus dem Kristallkörper aus, und wird dort von einem Detektor erfasst.

Die JP 5798244 B2 offenbart ein Sensorsystem mit einer senkrechten Orientierung der Anregung und Detektion. Das Sensorsystem weist ein Objektiv als Lichteinkopplung auf, wobei das Emissionslicht durch Totalreflektion an einer Kurzseite des Diamanten austritt, und mittels eines Detektors seitlich detektiert wird.

In der US 10,126,377 B2 ist ein Sensorsystem mit einem Kristallkörper offenbart, dessen Kristalldefekte mittels einer seitlichen Lichteinkopplung angeregt werden, wobei das Emissionslicht senkrecht hierzu mittels Lichtleitern zu Detektoren geführt wird.

Die US 2017/0234941 A1 offenbart ein Magnetometer mit einem Diamantsensor und mit einer Anregungslichtquelle sowie mit einem Diamantsensorgehäuse und mit einer Fotodiode. Die Anregungslichtquelle bestrahlt das Diamantsensorgehäuse mit Anregungslicht. Im Diamantsensor-Gehäuse ist entweder auf einer vorderen oder einer inneren Oberfläche ein Reflexionsfilm ausgebildet, der das Anregungslicht reflektiert. Die Fotodiode erfasst die Intensität der vom Diamantsensor erzeugten Fluoreszenz. Das Gehäuse des Diamantsensors enthält ein Fenster für die Fluoreszenzausgabe und ein Fenster für den Empfang des Anregungslichts. Die vom Diamantsensor erzeugte Fluoreszenz wird durch das Fluoreszenz-Ausgangsfenster ausgegeben. Das von der Anregungslichtquelle emittierte Anregungslicht wird durch das Anregungslichtempfangsfenster empfangen.

Der Erfindung liegt die Aufgabe zugrunde eine besonders geeignete Vorrichtung zur Erfassung einer physikalischen Größe anzugeben. Insbesondere soll eine einfache und effektive sowie räumlich aufgelöste Detektion von Emissionslicht ermöglicht werden.

Die Aufgabe wird erfindungsgemäß gelöst mit den Merkmalen des Anspruchs 1. Vorteilhafte Ausgestaltungen und Weiterbildungen sind Gegenstand der Unteransprüche.

Die erfindungsgemäße Vorrichtung ist zur Erfassung einer physikalischen Größe vorgesehen, sowie dafür geeignet und eingerichtet. Unter einer physikalischen Größe ist hierbei insbesondere eine an einem Objekt quantitativ bestimmbare Eigenschaft eines Vorgangs oder Zustands zu verstehen. Die physikalische Größe ist hierbei vorzugsweise eine vektorielle, also richtungsabhängige, Größe, wie beispielsweise ein mechanischer Druck oder ein elektrisches Feld. Vorzugsweise wird als physikalische Größe ein Magnetfeld erfasst.

Die Vorrichtung weist als Sensorelement einen Kristallkörper, beispielsweise einen Halbleiter- oder Seltenerdenkristall, auf, in welchem mindestens ein optisch aktiver Kristallgitterdefekt eingebettet ist. Der Kristallgitterdefekt ist insbesondere als ein Farbzentrum ausgeführt, welches als Reaktion auf ein Anregungslicht einer ersten Wellenlänge ein Emissionslicht (Fluoreszenzlicht) einer zweiten Wellenlänge emittiert, wobei die Stärke des Emissionslichts in Abhängigkeit der physikalischen Größe variiert. Die Wellenlängen des Anregungslichts und des Emissionslichts sind vorzugsweise unterschiedlich.

Die Vorrichtung weist weiterhin eine Lichteinkopplung, mittels welcher das Anregungslicht in den Kristallkörper eingekoppelt wird, und eine Detektionseinheit, mittels welcher das Emissionslicht detektiert wird, auf. Die Detektionseinheit ist hierbei vorzugsweise als eine Photodiode ausgeführt, so dass die Anzahl der emittierten Photonen und somit die Stärke des Emissionslichts, erfassbar ist.

Erfindungsgemäß sind die Anregung und die Detektion senkrecht zueinander orientiert. Dies bedeutet, dass die Lichteinkopplung und die Detektionseinheit an zueinander senkrecht orientierten Flächen des Kristallkörpers angeordnet sind.

Dadurch sind die Anregungsachse und die Detektionsachse quer oder senkrecht zueinander orientiert, so dass es in der Folge im Wesentlichen zu keiner Überlagerung des Anregungslichts und des Emissionslichts kommt.

Zwischen der Detektionseinheit und der zugeordneten Fläche des Kristallkörpersist eine lichtundurchlässige Struktur angeordnet ist, welche zumindest eine lichtdurchlässige Stelle als transparenten Bereich aufweist. Mit anderen Worten blockiert die Struktur bereichsweise die Ausbreitung des Emissionslichts. Dies bedeutet, dass die Struktur zumindest für die emittierte Wellenlänge der Kristalldefekte nicht transparent ist, und das Emissionslicht nur in den vorbestimmten transparenten Bereich zur Detektionseinheit austreten kann. Der transparente Bereich der Struktur wirkt hierbei effektiv als ein Sensorpixel, wobei das austretende Emissionslicht mittels der Detektionseinheit detektiert wird. Dadurch ist eine besonders geeignete Vorrichtung realisiert.

Die Struktur ist beispielsweise als eine metallische Maske oder Abschattung ausgeführt, welche die Planfläche des Kristallkörpers bereichsweise lichtundurchlässig abdeckt.

Der transparente Bereich ist beispielsweise als Strahlteiler ausgeführt, welcher das Anregungslicht reflektiert und das Emissionslicht transmittiert. In einer konstruktiv besonders einfachen Ausgestaltung ist der transparente Bereich als eine Aussparung oder eine Durchgangsöffnung der Struktur ausgeführt.

Erfindungsgemäß weist der Kristallkörper zwei parallele, axiale Planflächen (Planseiten) und mindestens eine hierzu senkrecht orientierte, transversale Seitenfläche auf, welche sich als Seitenkante zwischen den zwei Planflächen erstreckt. Die Seitenfläche ist nachfolgend auch als Transversalseite oder Stirnseite bezeichnet. Der Kristallkörper ist beispielsweise als ein Quader mit einer rechteckförmigen oder quadratischen Querschnittsfläche ausgeführt, wobei der Kristallkörper vier Seitenflächen aufweist.

Die Lichteinkopplung ist hierbei stirnseitig an mindestens einer Seitenfläche des Kristallkörpers angeordnet, wobei die Detektionseinheit parallel zu einer Planfläche angeordnet ist. Dadurch ist ein transversales oder laterales Sensordesign vorgesehen, bei welchem die optische Anregung seitlich, also von der transversalen oder lateralen Seitenfläche aus, erfolgt, und wobei die Detektionsachse im Wesentlichen senkrecht zu den axialen Planflächen orientiert ist.

In einer denkbaren Ausführungsform ist an jeder Seitenfläche des Kristallkörpers eine Lichteinkopplung vorgesehen, so dass eine etwa ringförmige Anregung realisiert ist, von welcher der Kristallkörper eingefasst ist.

Erfindungsgemäß weist die Struktur eine Anzahl von transparenten Bereichen, also mindestens zwei transparente Bereiche, auf. Dadurch ist eine Anzahl von Pixeln für die Detektion realisiert, wodurch die räumliche Auflösung der Vorrichtung verbessert wird. Die Abmessungen der Bereiche sowie deren relativer Abstand zueinander sind hierbei an die zu messende physikalische Größe angepasst.

Vorzugsweise ist je transparenten Bereich mindestens ein Kristallgitterdefekt vorgesehen. Geeigneterweise weist der Kristallkörper hierbei eine Vielzahl der Kristallgitterdefekten, also ein sogenanntes Ensemble, auf, welche den Kristallkörper durchsetzen. Dadurch wird das detektierbare Signal (Photonen des Emissionslichts) und damit die Sensitivität der Vorrichtung verbessert.

Die Vorrichtung ist als ein Gradiometer, also als eine Vorrichtung zur Erfassung einer Komponente eines Gradientenfeldes, vorzugsweise zur Erfassung eines Gradienten eines Magnetfeldes, ausgebildet. Hierbei wird eine Vektorkomponente der physikalischen Größe in den mindestens zwei durch die Bereiche freigestellten Sensorbereichen des Kristallkörpers registriert. Durch den festen Abstand der Bereiche untereinander ist der Gradient anschließend als Differenz der mindestens zwei Intensitäten des Emissionslichts bestimmbar.

In einer möglichen Ausbildung weist die Struktur zwei parallel zueinander beabstandet verlaufende transparente Bereiche auf, welche sich beispielsweise von einer Kante der Planfläche zu einer gegenüberliegenden Kante der Planfläche erstrecken. Dadurch sind zwei zueinander beabstandete Detektionsbereiche realisiert, welche eine einfache Bestimmung des Gradientenfeldes ermöglichen.

In bevorzugter Ausführung weist die Struktur mehrere transparente Bereiche oder Pixel auf, wobei jedem Pixel eine separate Detektoreinheit zugeordnet ist. Mit anderen Worten weist die Vorrichtung eine der Anzahl der Bereiche entsprechende Anzahl von Detektionseinheiten auf, wobei jeweils eine Detektionseinheit einem Bereich zugeordnet ist. Dadurch wird eine besonders einfache und zuverlässige Erfassung der Bereiche gewährleistet. Insbesondere ist somit eine getrennte Auswertung der Bereiche ermöglicht, wodurch eine einfache Gradiometrie realisierbar ist. Die Vorrichtung weist hierbei vorzugsweise mindestens zwei Durchführöffnungen als Bereiche auf, welchen jeweils eine Photodiode als Detektionseinheit zugeordnet ist.

Die Vorrichtung beziehungsweise das Gradiometer ist somit im Wesentlichen als eine Kamera für die physikalische Größe oder deren Gradientenfeld ausgeführt. Dies bedeutet, dass durch die Anzahl und Anordnung der transparenten Bereiche und/oder Detektionseinheiten ein Pixelgitter oder Pixelarray gebildet wird, mittels welchem die Vorrichtung als ein räumlich aufgelöster Sensor oder Detektor für die physikalische Größe oder deren Gradientenfeld ausgebildet ist. In einer bevorzugten Anwendung ist die Vorrichtung beispielsweise nach Art einer CCD-Kamera für Magnetfelder und/oder Magnetfeldgradienten ausgeführt.

Bei einer punktförmigen Lichtquelle breitet sich das Anregungslicht im Kristallkörper etwa konusförmig aus, wobei die schrägen Lichtstrahlen an den Oberflächen totalreflektiert werden, so dass mittels der seitlichen Einstrahlung im Wesentlichen das ganze Volumen des Kristallkörpers anregbar ist. Um die Ausleuchtung des Kristallvolumens mittels des Anregungslichts zu verbessern ist es in einer zweckmäßigen Ausbildung möglich, dass zumindest eine oder jede der parallel zur Anregungsrichtung orientierten Flächen des Kristallkörpers mit einer für das Anregungslicht reflektierenden Beschichtung versehen ist. Beispielsweise sind die oder jede Planfläche mit einer reflektierenden Beschichtung versehen. Insbesondere ist es in einer denkbaren Ausführung möglich, dass die Struktur reflektierend für das Anregungslicht ausgeführt ist. Mit anderen Worten sind die nicht transparenten Bereiche der Struktur reflektierend für die Wellenlänge des Anregungslichts.

In einer zweckmäßigen Ausgestaltung ist die Lichteinkopplung als eine Laserdiode oder als eine Leuchtdiode (engl.: light emitting diode, LED) ausgeführt, welche als Lichtquelle an einer Fläche, vorzugsweise stirnseitig an der mindestens einen Seitenfläche, angeordnet ist. Alternativ sind beispielsweise optische Fasern oder Waveguides als Lichteinkopplung denkbar, welche das Anregungslicht von einer beabstandeten Lichtquelle zu den (Seiten-)Flächen des Kristallkörpers führen und in diesen einstrahlen.

Ein zusätzlicher oder weiterer Aspekt der Erfindung sieht vor, dass zwischen der Struktur und der Detektionseinheit ein optisches Filterelement zur Filterung oder Blockierung des Anregungslichts, insbesondere von reflektiertem Anregungslicht, vorgesehen ist. Dadurch wird die Detektion des Emissionslichts weiter vereinfacht und die Sensitivität der Vorrichtung verbessert.

Die Struktur ist in einer bevorzugten Ausführung als eine metallische Mikrowellenstruktur (Waveguide odgl.) ausgebildet, mittels welcher Mikro- und/oder Radiowellenstrahlung zur Manipulation der Kristallgitterdefekte erzeugbar ist. Beispielsweise werden bei NV-Zentren Strahlungen im MHz-bis GHz-Bereich erzeugt, um Übergänge in den Energieniveaus (Energielevels) zu bewirken. Dadurch sind Pulssequenzen wie beispielsweise Hahn-Echo ausführbar, wodurch die Sensitivität der Vorrichtung, insbesondere bei zeitlich veränderlichen physikalischen Größen, weiter verbessert wird.

Die Konjunktion "und/oder" ist hier und im Folgenden derart zu verstehen, dass die mittels dieser Konjunktion verknüpften Merkmale sowohl gemeinsam als auch als Alternativen zueinander ausgebildet sein können.

In einer geeigneten Ausgestaltung ist die Struktur unmittelbar auf den Kristallkörper, beispielsweise auf die Planseite oder Planfläche, aufgebracht. Die vordefinierte Struktur ist hierbei beispielsweise direkt als eine (metallische) Maske mittels Lithographie auf die Oberfläche des Kristallkörpers aufgebracht. Alternativ ist die Struktur separat ausgeführt und möglichst bündig anliegend an der Seitenfläche positioniert. Der Zwischenraum zwischen der Fläche des Kristallkörpers und der Struktur ist hierbei geeigneterweise mit einem Medium wie beispielsweise Immersionsöl, einem Polymer, beispielsweise Polydimethylsiloxan (PDMS), oder einem flüssigen Deckglas gefüllt, damit ungewünschte Reflektionen und Verluste des Emissionslichts beim Übergang vom Kristallkörper zur Struktur weitestmöglich reduziert werden.

In einer geeigneten Ausführung ist der Kristallkörper als ein Diamant ausgeführt, wobei der Kristallgitterdefekt als ein Farbzentrum, insbesondere als ein Stickstofffehlstellen-Zentrum (NV-Zentrum), ausgeführt ist.

Unter einem Diamanten ist hierbei insbesondere ein synthetisches Einkristall-Diamantmaterial, welches insbesondere mittels einer chemischen Gasphasenabscheidung (engl.: Chemical Vapor Deposition, CVD) hergestellt wurde, zu verstehen. Der Diamant weist vorzugsweise eine möglichst hohe Reinheit und elektronische Qualität sowie eine möglichst geringe Anzahl von Gitterfehlern auf. Das Diamantmaterial weist beispielsweise einen Stickstoff- und/oder Boranteil kleiner 1 ppb (parts per billion) und einen Isotopenanteil von ¹³C-Kohlenstoff von etwa 1,1 % oder weniger auf. Die Farb- oder NV-Zentren sind künstlich in dem Diamantmaterial erzeugt, beispielsweise mittels einer aufgewachsenen Dotierungsschicht oder mittels einer Ionenimplantation mit anschließendem Ausheizen (Annealing).

Nachfolgend ist ein Ausführungsbeispiel der Erfindung anhand einer Zeichnung näher erläutert. Darin zeigen in schematischen und vereinfachten Darstellungen:
- Fig. 1: in Seitenansicht eine erste Ausführungsform einer Vorrichtung zur Erfassung einer physikalischen Größe, mit einem Kristallkörper,
- Fig. 2: in Draufsicht die Vorrichtung gemäß der ersten Ausführungsform mit Blick auf eine Oberseite des Kristallkörpers,
- Fig. 3: in Draufsicht die Vorrichtung gemäß der ersten Ausführungsform mit Blick auf eine Unterseite des Kristallkörpers,
- Fig. 4: in Seitenansicht eine zweite Ausführungsform der Vorrichtung,
- Fig. 5: in Draufsicht die Vorrichtung gemäß der zweiten Ausführungsform mit Blick auf eine Unterseite des Kristallkörpers, und
- Fig. 6: in Draufsicht eine Struktur der Vorrichtung gemäß einer dritten Ausführungsform.

Einander entsprechende Teile und Größen sind in allen Figuren stets mit den gleichen Bezugszeichen versehen.

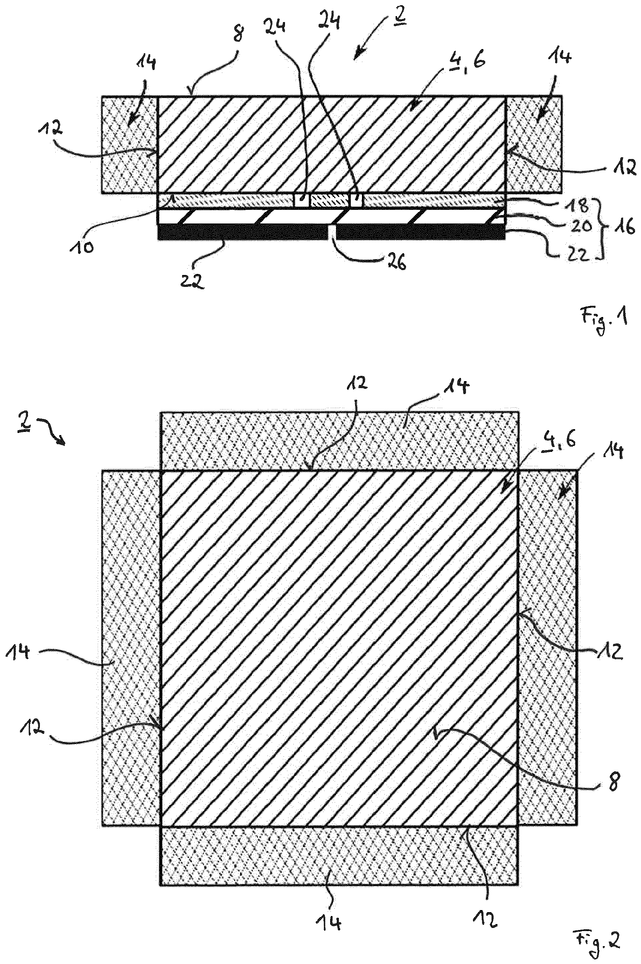

Die in der Fig. 1 dargestellte Vorrichtung 2 ist zur Erfassung einer physikalischen Größe ausgebildet. Die Vorrichtung 2 ist hierbei insbesondere als ein Gradiometer zur Erfassung von Magnetfeldern beziehungsweise Magnetfeldgradienten ausgeführt. Dies bedeutet, dass die zu erfassende physikalische Größe insbesondere ein Magnetfeld oder ein Magnetfeldgradient ist.

Die Vorrichtung 2 weist einen etwa quaderförmigen Kristallkörper 4 auf. In dem Kristallkörper 4 ist ein Ensemble von nicht näher dargestellten Kristallgitterdefekten 6 eingebettet. Die Kristallgitterdefekte 6 sind hierbei optisch aktiv und weisen eine Fluoreszenz auf, welche Abhängig von der Stärke und/oder Orientierung der zu erfassenden physikalischen Größe ist.

Geeigneterweise ist im Wesentlichen das gesamte Kristallvolumen des Kristallkörpers 4 von den Kristallgitterdefekten 6 durchsetzt. Beispielsweise weisen die Kristallgitterdefekte 6 eine Dichte von etwa 1 ppm (parts per million), also 0,0001 % oder etwa 10¹⁷ cm⁻³, im Kristallgitter des Kristallkörpers 4 auf.

In bevorzugter Ausführung ist der Kristallkörper 4 als ein Diamant ausgeführt, wobei die Kristallgitterdefekte 6 vorzugsweise als Stickstofffehlstellen-Zentren ausgeführt sind.

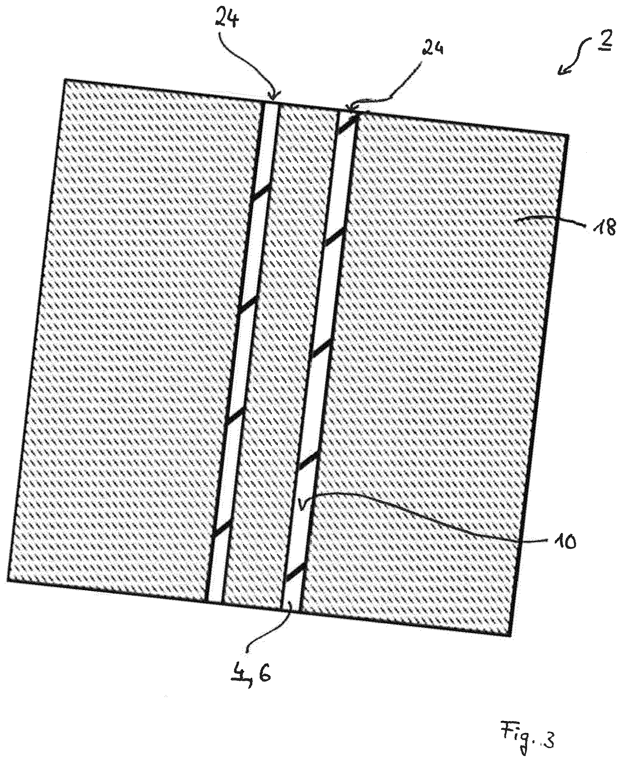

In der in den Figuren 2 und 3 gezeigten Ausführungsform, weist der Kristallkörper 4 eine quadratische Grund- oder Querschnittsform auf. Der Kristallkörper 4 weist somit zwei quadratische Planflächen als Oberseite 8 und Unterseite 10 sowie vier Seitenflächen 12 als Umfangsseiten oder Stirnseiten auf.

An den vier Seitenflächen 12 ist jeweils eine Lichteinkopplung 14, beispielsweise in Form jeweils einer oder mehrerer Laserdioden, vorgesehen welche ein Anregungslicht in das Kristallvolumen des Kristallkörpers 4 einstrahlen. Die Einstrahlung des Anregungslichts kann hierbei kontinuierlich, also dauerhaft, oder gepulst erfolgen.

Das Anregungslicht ist hierbei dazu vorgesehen und eingerichtet die Kristallgitterdefekte 6 optisch anzuregen. Die Kristallgitterdefekte 6 emittieren in der Folge ein Emissionslicht, wobei die Stärke oder Intensität, also die Anzahl der emittierten Photonen, abhängig von der Stärke und/oder Orientierung der zu erfassenden physikalischen Größe ist.

Bei Stickstofffehlstellen-Zentren als Kristallgitterdefekte 6 wird als Anregungslicht beispielsweise ein grünes Laserlicht mit einer Wellenlänge von etwa 532 nm (Nanometer) verwendet, wobei ein rotes Emissionslicht im Wellenlängenbereich um 637 nm emittiert wird.

Die Oberseite 8 ist hierbei als die der zu messenden Größe zugewandte Seite, also als eine Detektorseite oder Erfassungsseite, ausgebildet. Die zu messende Größe wird also relativ zu der Oberseite 8 an die Vorrichtung 2 herangeführt. An der gegenüberliegenden Unterseite 10 ist ein Detektionssystem 16 zur Erfassung des Emissionslichts - und somit mittelbar zur Erfassung der physikalischen Größe - vorgesehen.

Das Detektionssystem 16 weist in dieser Ausführung eine Struktur 18 und ein optisches Filterelement 20 sowie zwei Detektionseinheiten 22 auf, welche entlang einer senkrecht zu den Planflächen 8, 10 orientierten Stapelrichtung übereinandergestapelt angeordnet sind.

Die Struktur 18 ist als eine elektrisch leitfähige Mikrowellenstruktur zur Ausstrahlung von Radio- und/oder Mikrowellenstrahlung, insbesondere im MHz- (Megahertz) bis GHz-Bereich, ausgeführt. Durch die Radio- und/oder Mikrowellenstrahlung können Pulssequenzen, wie beispielsweise ein Hahn-Echo, zur Manipulation der Kristallgitterdefekte 6 eingestrahlt werden, wodurch die Sensitivität der Vorrichtung 2 verbessert wird.

Die Struktur 18 ist hierbei insbesondere als eine sogenannte Stripline- oder Streifenleiter-Struktur mit zwei geerdeten Flächen (Ground planes) und einem zentralen, jeweils beabstandet zu den Flächen angeordneten, Leiter ausgeführt. Die Struktur 18 ist hierbei unmittelbar mittels Lithographie auf die Unterseite 10 des Kristallkörpers 4 aufgebracht. Beispielsweise ist die Struktur 18 als ein Schichtsystem einer aufgedampften Titanschicht als Haftschicht und einer darauf mittels Galvanotechnik (Elektroplattieren) aufgewachsenen Goldschicht ausgeführt. Die Struktur 18 ist hierbei sowohl für das Anregungslicht als auch das Emissionslicht optisch undurchlässig oder nicht transparent. Insbesondere ist die Struktur 18 reflektierend sowohl für das Anregungslicht als auch das Emissionslicht.

Die Struktur 18 weist hierbei zwei transparente oder lichtdurchlässige Bereiche 24 auf, welche durch die streifen- oder schlitzförmigen Aussparungen zwischen den geerdeten Flächen und dem zentralen Leiter gebildet sind. Durch die Ausführung als Streifenleiter-Struktur verlaufen die Bereiche 24 parallel zueinander beabstandet von einer Kante der Unterseite 10 zu einer gegenüberliegenden Kante der Unterseite 10 (vgl. Fig. 3). Dies bedeutet, dass das Emissionslicht und das Anregungslicht an der Unterseite 10 lediglich durch die Bereiche 24 der Struktur 18 aus dem Kristallkörper 4 austreten können.

Das optische Filterelement 20 ist hierbei zur Filterung oder Blockierung des Anregungslichts vorgesehen, so dass lediglich das Emissionslicht zu den Detektionseinheiten 22 gelangt. Die beispielsweise als Photodioden, insbesondere als Lawinen- oder Avalanche-Diode, ausgeführten Detektionseinheiten 22 sind hierbei mittels eines Spalts 26 voneinander beabstandet angeordnet. Vorzugsweise ist hierbei jeweils eine Detektionseinheit 22 einem Bereich 24 zugeordnet, so dass das Emissionslicht und somit die physikalische Größe räumlich getrennt voneinander erfasst wird. Dadurch sind eine besonders einfache Auswertung und Bestimmung eines Gradienten oder einer Orientierung der Größe ermöglicht.

Wird eine magnetische Probe an die Oberfläche 8 angenähert, so erfassen die Kristallgitterdefekte 6 ausgehend von der Struktur mit zunehmender Entfernung ein schwächeres Magnetfeld. Dadurch tritt aus den Bereichen 24 Emissionslicht unterschiedlicher Intensität aus. Aus der bekannten relativen Lage der Probe zur Oberfläche 8 und dem bekannten Abmessungen und Abständen der Bereiche 24 ist somit anhand des Intensitätsunterschieds ein Gradient oder Verlauf des von der Probe ausgehenden Magnetfelds ermöglicht.

In einer denkbaren Dimensionierung weist der Kristallkörper 4 beispielsweise eine Kanten- oder Seitenlänge von 2 mm (Millimeter) auf. Die Bereiche 24 der Struktur weisen hierbei beispielsweise eine Breite, also eine lichte Weite, von etwa 50 µm (Mikrometer) auf.

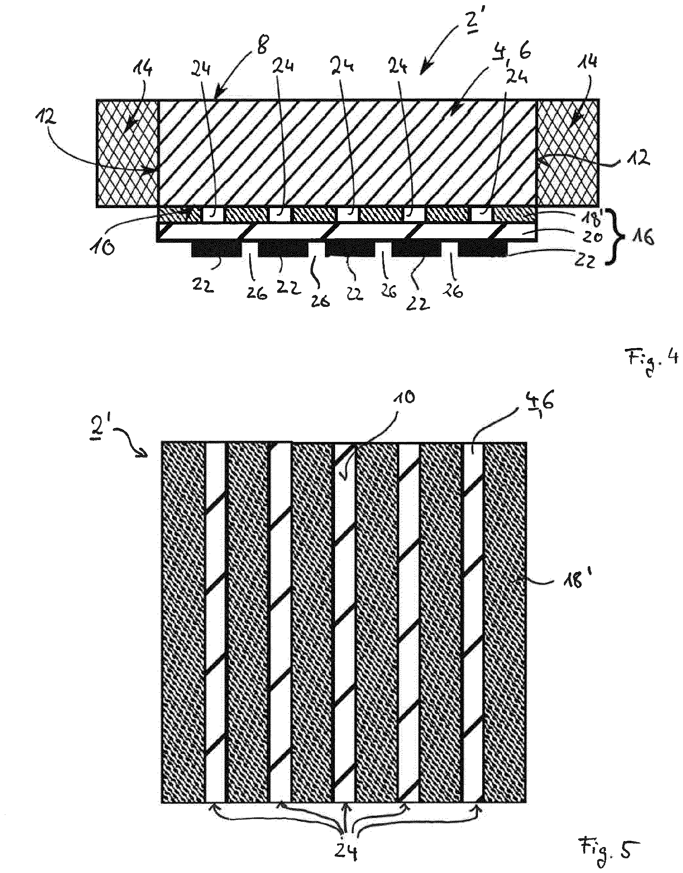

Anhand der Figuren 4 und 5 ist nachfolgend ein zweites Ausführungsbeispiel der Erfindung näher erläutert. In dieser Ausführungsform weist die Vorrichtung 2' eine Struktur 18' mit fünf parallelen, linienförmigen oder spaltförmigen, Aussparungen als Bereiche 24 auf, welchen jeweils eine Detektionseinheit 22 zugeordnet ist. Durch die höhere Anzahl an Bereichen 24 und Detektionseinheiten 22 weist die Vorrichtung 2' eine verbesserte räumliche Auflösung auf.

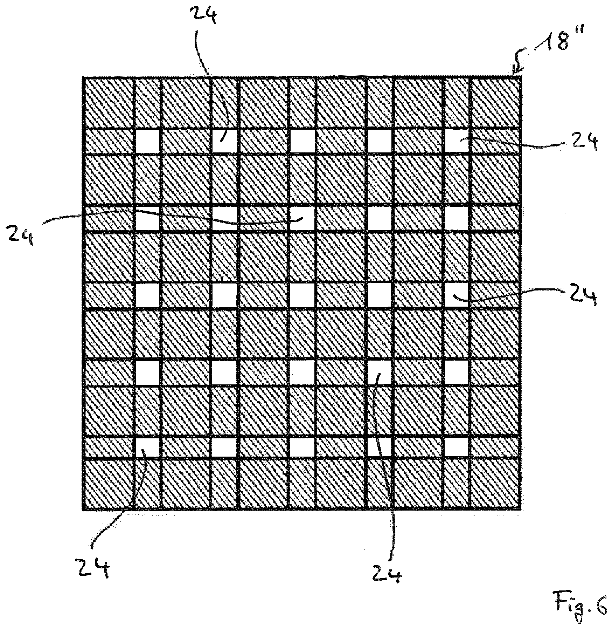

In der Fig. 6 ist die Struktur 18" einer dritten Ausführungsform dargestellt. Die Struktur 18" weist in dieser Ausbildung fünfundzwanzig (25) quadratische Aussparungen als Bereiche 24 auf, welche in der Fig. 6 lediglich beispielhaft mit Bezugszeichen versehen sind. Durch die etwa gitterartige oder rasterartige Struktur 18" ist somit ein Pixelarray von Bereichen 24 gebildet, welche vorzugsweise jeweils einzeln mittels einer zugeordneten Detektionseinheit 22 überwacht werden. Dadurch ist eine besonders hohe räumliche Auflösung realisiert.

Die Erfindung ist nicht auf die vorstehend beschriebenen Ausführungsbeispiele beschränkt. Vielmehr können auch andere Varianten der Erfindung von dem Fachmann hieraus abgeleitet werden, ohne den Gegenstand der Erfindung zu verlassen. Insbesondere sind ferner alle im Zusammenhang mit den Ausführungsbeispielen beschriebenen Einzelmerkmale auch auf andere Weise miteinander kombinierbar, ohne den Gegenstand der Erfindung zu verlassen.

So ist es beispielsweise möglich, dass das Detektionssystem 16 als zueinander beabstandete Komponenten ausgeführt ist, wobei das Emissionslicht beispielsweise über Waveguides, optische Fasern und/oder über Luft, gegebenenfalls mittels Spiegeln und/oder weiteren optischen Elementen, von einer Komponente zur nächsten geleitet wird. Ebenso denkbar ist beispielsweise das Einbringen eines Mediums zwischen den Komponenten, wie beispielsweise ein Immersionsöl oder einem geeigneten Polymer, beispielsweise Polydimethylsiloxan (PDMS) oder Polymethylmethacrylat (PMMA). Geeigneterweise sind jedoch zumindest das Filterelement 20 und die Detektionseinheiten 22 möglichst nahe beieinander angeordnet, so dass der Eintritt von Streulicht oder dergleichen in die Detektionseinheiten 22 verhindert wird.

Ebenso denkbar ist beispielsweise, dass die Oberseite 8 mit einer reflektierenden Beschichtung versehen ist. Dadurch wird einerseits die Ausleuchtung des Kristallvolumens mittels des Anregungslichts verbessert, sowie andererseits Emissionslicht von der Oberseite 8 zu der Unterseite 10, und somit zu den Bereichen 24, reflektiert, so dass eine verbesserte Signalqualität ermöglicht ist.

Weiterhin ist es beispielsweise möglich, die separaten Detektionseinheiten 22 durch einen räumlich aufgelösten Sensor oder Detektor, beispielsweise eine CCD-Kamera, zu ersetzen.

### Bezugszeichenliste

- 2,2': Vorrichtung
- 4: Kristallkörper
- 6: Kristallgitterdefekt
- 8: Planfläche, Oberseite
- 10: Planfläche, Unterseite
- 12: Seitenfläche
- 14: Lichteinkopplung
- 16: Detektionssystem
- 18, 18', 18": Struktur
- 20: Filterelement
- 22: Detektionseinheit
- 24: Bereich
- 26: Spalt

## Patentansprüche

1. Gradiometer (2, 2') zur Erfassung eines Gradientenfeldes einer physikalischen Größe, aufweisend einen Kristallkörper (4) mit mindestens einem optisch aktiven Kristallgitterdefekt (6), welches als Reaktion auf ein Anregungslicht ein Emissionslicht in Abhängigkeit der physikalischen Größe emittiert, und eine Lichteinkopplung (14) zur Einkopplung von Anregungslicht, sowie eine Detektionseinheit (22) zur Detektion von Emissionslicht,
- wobei der Kristallkörper (4) zwei parallele Planflächen (8, 10) und mindestens eine hierzu senkrecht orientierte Seitenfläche (12) aufweist,
- wobei die Lichteinkopplung (14) und die Detektionseinheit (22) an zueinander senkrecht orientierten Flächen (12, 10) des Kristallkörpers (4) angeordnet sind,
- wobei die Lichteinkopplung (14) an der Seitenfläche (12) und die Detektionseinheit (22) parallel zu einer Planfläche (10) angeordnet ist, und
- wobei zwischen der Detektionseinheit (22) und der Planfläche (10 des Kristallkörpers (4) eine das Emissionslicht zumindest bereichsweise blockierende Struktur (18, 18', 18") vorgesehen ist, welche eine Anzahl von für das Emissionslicht transparenten Bereichen (24) aufweist.

2. Gradiometer (2, 2') nach Anspruch 1,
**dadurch gekennzeichnet,**
**dass** der transparente Bereich (24) als Aussparung oder Durchgangsöffnung der Struktur (18, 18', 18") ausgeführt ist.

3. Gradiometer (2, 2') nach Anspruch 1 oder 2,
**dadurch gekennzeichnet,**
**dass** die Struktur (18, 18') zwei parallel zueinander beabstandet verlaufende transparente Bereiche (24) aufweist.

4. Gradiometer (2, 2') nach Anspruch 2,
**dadurch gekennzeichnet,**
**dass** eine der Anzahl der Bereiche (24) entsprechende Anzahl von Detektionseinheiten (22) vorgesehen ist, wobei jeweils eine Detektionseinheit (22) einem Bereich (24) zugeordnet ist.

5. Gradiometer (2, 2') nach einem der Ansprüche 1 bis 4,
**dadurch gekennzeichnet,**
**dass** eine oder jede Fläche (10, 8) parallel zur Lichteinkopplung (14) mit einer für das Anregungslicht reflektierenden Beschichtung versehen ist.

6. Gradiometer (2, 2') nach einem der Ansprüche 1 bis 5,
**dadurch gekennzeichnet,**
**dass** die Struktur (18, 18', 18") reflektierend für das Anregungslicht ist.

7. Gradiometer (2, 2') nach einem der Ansprüche 1 bis 6,
**dadurch gekennzeichnet,**
**dass** die Lichteinkopplung (14) als eine Laserdiode ausgeführt ist, welche als Lichtquelle stirnseitig an der Fläche (12) des Kristallkörpers (4) angeordnet ist.

8. Gradiometer (2, 2') nach einem der Ansprüche 1 bis 7,
**dadurch gekennzeichnet,**
**dass** zwischen der Struktur (18, 18', 18") und der Detektionseinheit (22) ein optisches Filterelement (20) zur Filterung oder Blockierung des Anregungslichts vorgesehen ist.

9. Gradiometer (2, 2') nach einem der Ansprüche 1 bis 8,
**dadurch gekennzeichnet,**
**dass** die Struktur (18, 18', 18") als eine metallische Mikrowellenstruktur zur Ausstrahlung von Radio- und/oder Mikrowellenstrahlung ausgeführt ist, mittels welcher der Kristallgitterdefekt (6) manipulierbar ist.

10. Gradiometer (2, 2') nach einem der Ansprüche 1 bis 9,
**dadurch gekennzeichnet,**
**dass** die Struktur (18, 18', 18") unmittelbar auf den Kristallkörper (4) aufgebracht ist.

11. Gradiometer (2, 2') nach einem der Ansprüche 1 bis 10,
**dadurch gekennzeichnet,**
**dass** der Kristallkörper (4) als Diamant ausgeführt ist, wobei der Kristallgitterdefekt (6) als ein Farbzentrum, insbesondere als ein Stickstofffehlstellen-Zentrum, ausgeführt ist.
